# EUROPEAN PATENT APPLICATION

(11) **EP 4 333 044 A1**
(43) Date of publication of application: **06.03.2024**
(21) Application number: 22795644.8
(22) Date of filing: 20.04.2022
(51) Int. Cl.: H01L 23/12, H01L 33/62, H01L 33/64, H01S 5/02315

(54) **SUBSTRATE, PACKAGE, ELECTRONIC COMPONENT, AND LIGHT EMITTING DEVICE**

(30) Priority: 26.04.2021 JP 2021074366
(71) Applicant: Kyocera Corporation, Kyoto-shi Kyoto 612-8501 (JP)
(72) Inventor: ONITSUKA, Yoshitomo, Kyoto-shi, Kyoto 612-8501 (JP); YAMANAKA, Yuji, Kyoto-shi, Kyoto 612-8501 (JP)
(74) Representative: Viering, Jentschura & Partner mbB Patent- und Rechtsanwälte
(86) International application number: PCT/JP2022/018247
(87) International publication number: WO 2022/230731

(57) **Abstract**

To reduce conductor resistance and improve heat dissipation. A substrate includes a first substrate having a first surface on which an element is to be mounted, a second surface located opposite the first surface, and a first side surface connecting the first surface and the second surface, a second substrate larger than the first substrate and having a third surface supporting the first substrate and a fourth surface located opposite the third surface, and first via conductors electrically connecting the first surface and the second surface and exposed on the first side surface of the first substrate from the first surface to the second surface.

## Description

### TECHNICAL FIELD

The present disclosure relates to a substrate, a package, an electronic component, and a light emitting device.

### BACKGROUND OF INVENTION

Depending on a type or an application of an element, one method to raise a mounting position of the element is to mount the element on a surface of a protruding portion of a substrate having the protruding portion. For example, a light emitting module described in Patent Document 1 includes a carrier (substrate) on which a semiconductor laser mounted on a submount (protruding portion) and a lens component are mounted.

### CITATION LIST

### PATENT LITERATURE

Patent Document 1: JP 2013-80900 A

### SUMMARY

In an aspect of the present disclosure, a substrate includes a first substrate having a first surface on which an element is to be mounted, a second surface opposite the first surface, and a first side surface connecting the first surface and the second surface, a second substrate larger than the first substrate and having a third surface supporting the first substrate and a fourth surface opposite the third surface, and first via conductors configured to electrically connect the first surface and the second surface and exposed on the first side surface of the first substrate from the first surface to the second surface.

In an aspect of the present disclosure, a package includes the substrate and a lid.

In an aspect of the present disclosure, an electronic component includes the substrate or the package, and an element mounted in the package.

In an aspect of the present disclosure, a light emitting device includes the substrate or the package, and an element mounted in the package, in which the element is a light emitting element.

### BRIEF DESCRIPTION OF THE DRAWINGS

FIG. 1 is a perspective view of a substrate according to an embodiment of the present disclosure.
FIG. 2 includes a top view, a cross-sectional view, side views, and a bottom view of the substrate.
FIG. 3 is an exploded perspective view of the substrate.
FIG. 4 is a top view of a first substrate included in the substrate.
FIG. 5 is a schematic plan view schematically illustrating an outer edge of a first via conductor and a side of a first surface when an angle θ illustrated in FIG. 4 is changed.
FIG. 6 includes a top view, a cross-sectional view, side views, and a bottom view of a substrate as a variation.
FIG. 7 includes a top view, a cross-sectional view, side views, and a bottom view of a substrate as a variation.
FIG. 8 includes a top view, a cross-sectional view, side views, and a bottom view of a substrate as a variation.
FIG. 9 is an enlarged top view of a first substrate of the variation.
FIG. 10 is a top view of a first substrate as a variation.
FIG. 11 is an exploded perspective view of an electronic component including the substrate according to the embodiment of the present disclosure.
FIG. 12 includes a top view, a cross-sectional view, and a side view of the electronic component.
FIG. 13 includes cross-sectional views of exemplary light emitting devices in each of which an inner surface of a lid and a first via conductor are bonded with a bonding material.
FIG. 14 is an exploded perspective view of another exemplary package.
FIG. 15 is an exploded perspective view of another exemplary package.

### DESCRIPTION OF EMBODIMENTS

### First Embodiment

An exemplary embodiment of the present disclosure will be described in detail below with reference to the accompanying drawings.

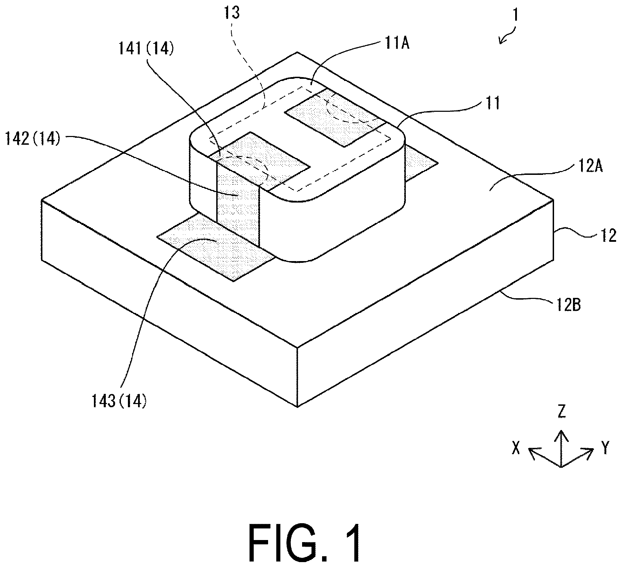

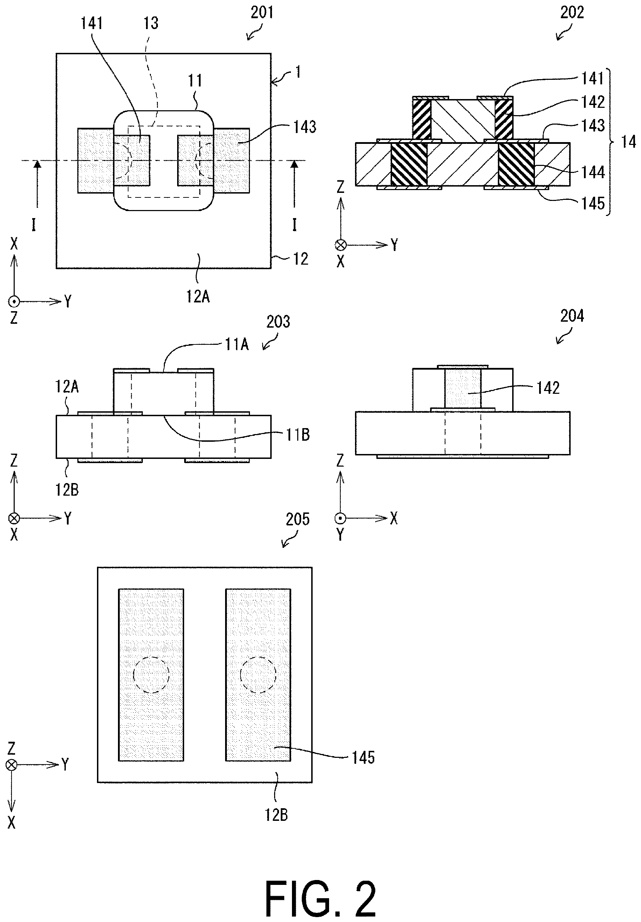

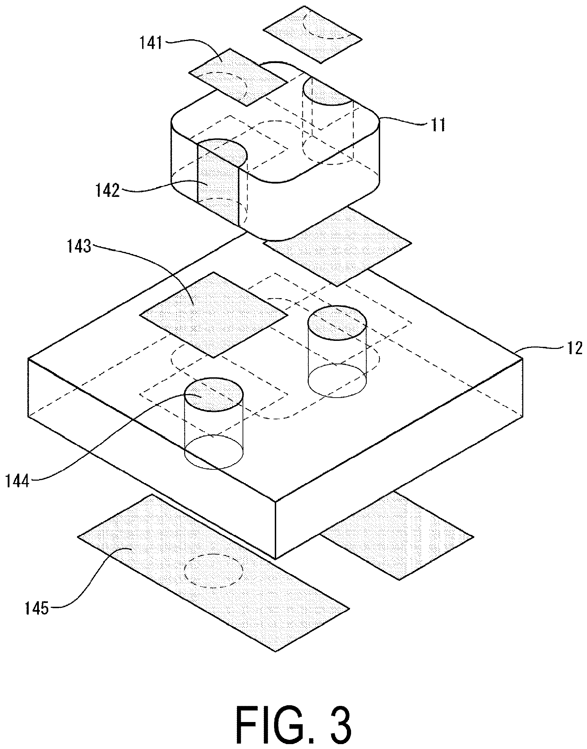

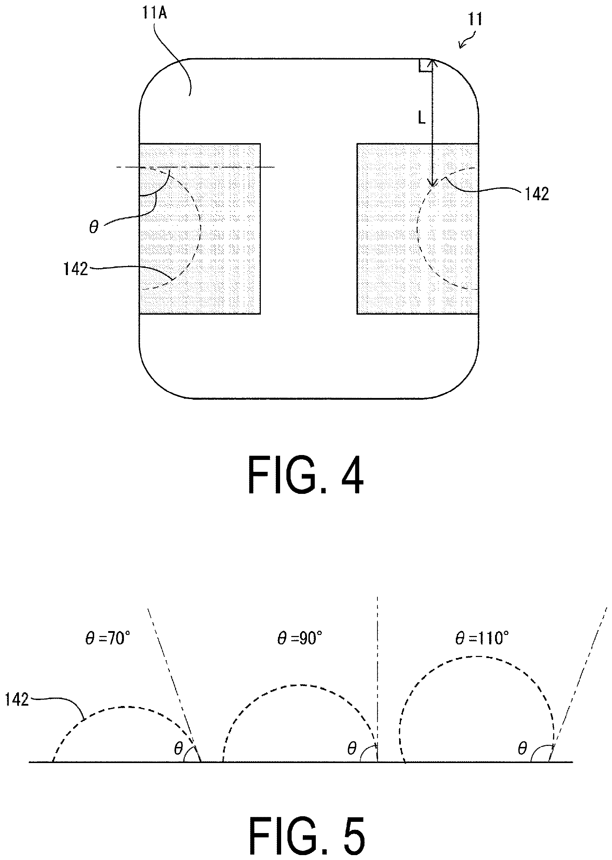

FIG. 1 is a perspective view of a substrate 1 according to the present embodiment. FIG. 2 includes a top view, a cross-sectional view, side views, and a bottom view of the substrate 1. In FIG. 2, a view indicated by reference numeral 201 is the top view of the substrate 1, and a view indicated by reference numeral 202 is the cross-sectional view taken along line I-I in the view indicated by reference numeral 201. In FIG. 2, a view indicated by reference numeral 203 is a side view of the substrate 1 when viewed from a negative direction of an X-axis, and a view indicated by reference numeral 204 is a side view of the substrate 1 when viewed from a positive direction of a Y-axis. A view indicated by reference numeral 205 in FIG. 2 is the bottom view of the substrate 1. FIG. 3 is an exploded perspective view of the substrate 1. FIG. 4 is a top view of a first substrate 11 included in the substrate 1.

In the accompanying drawings, the substrate 1 is assumed to be located on an X-Y plane in a virtual XYZ space. In this specification, an upward direction refers to a positive direction of a virtual Z-axis. The terms "up/top" and "down/bottom" are used in the following description by way of convenience and are not to be construed as limiting in the actual use of the substrate 1 or the like. A thickness direction of the substrate 1 refers to the direction of the Z-axis.

The substrate 1 is a substrate for mounting an element and functions as a support for supporting the element. The substrate 1 can be used for mounting an element that requires heat dissipation and/or an element that requires reduction in conductor resistance. More specifically, the substrate 1 can be used for mounting, for example, an element such as a light emitting element such as a light emitting diode (LED) or a laser diode (LD), a light receiving element such as a photo diode (PD), a charge coupled device (CCD) type or a complementary metal oxide semiconductor (CMOS) type imaging element, or a sensor element such as an acceleration sensor.

### Configuration of Substrate 1

As illustrated in FIGs. 1 to 3, the substrate 1 includes the first substrate 11 and a second substrate 12 that supports the first substrate 11 and is larger than the first substrate 11. Specifically, when viewed in plan from the Z-axis direction, the second substrate 12 is larger than the first substrate 11. Therefore, part of a third surface 12A (upper surface) of the second substrate 12 is covered with the first substrate 11, and at least part of a surrounding area is not covered. The first substrate 11 has, for example, a rectangular shape, and has a first surface 11A having a region on which an element is to be mounted (hereinafter referred to as an element mounting region 13) and a second surface 11B located opposite the first surface 11A. The second substrate 12 has the third surface 12A supporting the first substrate 11 and a fourth surface 12B located opposite the third surface 12A. The first substrate 11 and the second substrate 12 have, for example, a rectangular shape. The shape of the first substrate 11 and the second substrate 12 is not limited to rectangular, and may be circular or polygonal.

The element mounting region 13 is a region on which an element is to be mounted on the first surface 11A, and is a region indicated by dashed lines in each of the accompanying drawings. In the drawings, a shape of the element mounting region 13 is square, but is not limited thereto, and may be a shape corresponding to a shape of an element to be mounted.

As the first substrate 11 and the second substrate 12, a ceramic such as an aluminum oxide sintered body (alumina ceramic), an aluminum nitride sintered body, a silicon nitride sintered body, a mullite sintered body, or a glass ceramic sintered body can be used. When the first substrate 11 and the second substrate 12 are, for example, aluminum oxide sintered bodies, a slurry is prepared by adding and mixing a suitable organic binder, solvent, and the like with raw material powders such as aluminum oxide (Al₂O₃), silicon oxide (SiO₂), magnesium oxide (MgO), and calcium oxide (CaO). A ceramic green sheet is produced by forming this slurry into a sheet by employing a well-known doctor blade method, calender roll method, or the like. Subsequently, this ceramic green sheet is subjected to an appropriate punching process, and multiple ceramic green sheets are stacked to form a green body, which is then fired at a high temperature (approximately 1600°C) to produce the first substrate 11 and the second substrate 12.

Wiring conductors 14 are provided on the surface and inside of the substrate 1. For example, in the example illustrated in FIGs. 1 to 3, the substrate 1 includes connection pads 141, first via conductors 142, wiring layers 143, second via conductors 144, and terminal electrodes 145 as the wiring conductors 14.

The connection pads 141 for connection with an element are provided on an upper surface of the substrate 1 (first surface 11A). The terminal electrodes 145 for connection with an external electrical circuit are provided on a lower surface of the substrate 1 (fourth surface 12B). The terminal electrodes 145 are not limited to being provided on the lower surface of the substrate 1, and may be provided on side surfaces from the lower surface or on the side surfaces of the substrate 1. These connection pads 141 and the terminal electrodes 145 are electrically connected by the first via conductors 142, the wiring layers 143, and the second via conductors 144 provided on the surface and inside of the substrate 1.

The connection pads 141 and the terminal electrodes 145 mainly contain, for example, metals such as tungsten, molybdenum, manganese, copper, silver, palladium, gold, platinum, nickel, or cobalt, or alloys containing any of these metals as conductor materials. The connection pads 141 and the terminal electrodes 145 are formed on the surfaces of the substrate 1 as metal layers such as metallization layers or plating layers of a conductor material. The wiring layers 143 are formed inside the substrate 1 by metallization of a conductor material. The first substrate 11 and the second substrate 12 are different in size. Thus, the wiring layers 143 placed between the first substrate 11 and the second substrate 12 may be exposed on the surface of the second substrate 12.

When the connection pads 141, the wiring layers 143, and the terminal electrodes 145 are, for example, metallization layers of tungsten, they can be formed by printing a metal paste prepared by mixing tungsten powder with an organic solvent and an organic binder at predetermined positions on the ceramic green sheets to be the substrate 1 by a screen printing method or the like and firing the paste. A plating layer of nickel, gold, or the like may be further deposited on exposed surfaces of the metallization layers to serve as the connection pads 141, the wiring layers 143, and the terminal electrodes 145 by using an electrolytic plating method, electroless plating method, or the like.

The first via conductors 142 are via conductors that electrically connect the first surface 11A side and the second surface 11B side and are exposed on the side surfaces of first substrate 11 from the first surface 11A to the second surface 11B. The first via conductors 142 electrically connect conductors on the first surface 11A and conductors on the second surface 11B. To be specific, the first via conductors 142 electrically connect the connection pads 141 on the first surface 11A and the wiring conductors (wiring layers 143) on the second surface. The second via conductors 144 are via conductors that electrically connect the third surface 12A side and the fourth surface 12B side. The second via conductors 144 electrically connect conductors on the third surface 12A and conductors on the fourth surface 12B. To be specific, the second via conductors 144 electrically connect the wiring layers 143 on the third surface 12A and the terminal electrodes 145 on the fourth surface 12B.

The term via conductors may be used as a generic term for the first via conductors 142 and the second via conductors 144. That is, the via conductors are conductors passing through the first substrate 11 or the second substrate 12. The via conductors may be formed at predetermined positions in the ceramic green sheet prior to printing of the metal paste for forming the connection pads 141, the wiring layers 143, and the terminal electrodes 145. For example, first, through holes for via conductors are formed in the ceramic green sheet for the first substrate 11 or the second substrate 12 by a machining method such as stamping using a die or punching or laser beam machining. Thereafter, the through holes are filled with a metallization paste for via conductors by the above printing method, and the via conductors are formed by firing together with the ceramic green sheet for the first substrate 11 or the second substrate 12. The metallization paste is prepared by kneading the metal powder described above with an appropriate solvent and binder to adjust viscosity to an appropriate level. The metallization paste may contain glass powder or ceramic powder in order to increase bonding strength with the first substrate 11 or the second substrate 12. The via conductors other than the first via conductors 142 have, for example, a circular shape when viewed in plan from the Z-axis direction. That is, for example, in the first substrate 11 of the present embodiment, the second via conductors 144 are cylindrical. However, the shape of the via conductors is not limited to cylindrical, and may be oval, polygonal, or prismatic, for example.

In the example illustrated in FIGs. 1 to 3, all of the via conductors included in the first substrate 11 are the first via conductors 142, but the first substrate 11 may include via conductors that are not exposed on the side surfaces of the first substrate 11.

The first via conductors 142 have, for example, a semi-circular shape when viewed in plan from the Z-axis direction. That is, the first via conductors 142 may be, for example, semi-cylindrical. The shape of the first via conductors 142 when viewed in plan is not limited to semi-circular, and may be semi-elliptical or rectangular. When the shape of the first via conductors 142 as viewed in plan is a shape without corners such as a semi-circular shape or a semi-elliptical shape, the likelihood of cracks in the first substrate 11 originating from the corners can be reduced. The sizes of the multiple first via conductors 142 included in the first substrate 11 may be different from each other.

The first via conductors 142 may be formed as follows, for example. That is, (i) in the ceramic green sheet to be the first substrate 11, forming via conductors based on positions of the first via conductors 142 in the first substrate 11. (ii) Punching out the first substrate 11 such that at least part of the via conductors is exposed on the side surfaces of the first substrate 11 using a die corresponding to the shape of the first substrate 11. For example, the first via conductors 142 having a semi-cylindrical shape can be formed by forming cylindrical via conductors in (i) and punching out in (ii). The exposed surfaces of the first via conductors 142 may be further coated with a plating layer of nickel, gold, or the like using an electrolytic plating method, an electroless plating method, or the like.

The step (ii) may be performed after the ceramic green sheet to be the second substrate 12 is positioned below the ceramic green sheet to be the first substrate 11, with the first substrate 11 and the second substrate 12 aligned, so that they have a predetermined positional relationship. In this case, an appropriate binder obtained by adding and mixing a resin, a solvent, and the like may be applied to a portion to be the second surface 11B of the first substrate 11, and a portion to be the first substrate 11 may be pressed against the portion to be the third surface 12A of the second substrate 12 for adhesion while punching out the portion to be the first substrate 11. Thus, by punching out the ceramic green sheet to be the first substrate 11 from above using a die, the punching process of the portion to be the first substrate 11 and the stacking step of the portion to be the first substrate 11 and the portion to be the second substrate 12 may be performed simultaneously. By simultaneously performing the punching process and the stacking step, positional accuracy when mounting the first substrate 11 on the second substrate 12 may be improved.

When the substrate 1 is used to mount an element described above, the substrate 1 is required to have low conductor resistance and high heat dissipation in the wiring included in the substrate 1. In the substrate 1 according to the present embodiment, the connection pads 141 connected to the element and the terminal electrodes 145 are connected by the via conductors having wider cross-sectional areas than connection wires or the like, thereby achieving low conductor resistance. The via conductors included in the first substrate 11 close to the element are exposed on the side surfaces of the first substrate 11, which provide excellent heat dissipation.

Since the first substrate 11 is smaller than the second substrate 12, an area occupied by the wiring conductors 14 is relatively large with respect to an area of the first substrate 11 in a horizontal cross section of the first substrate 11 when viewed in plan. Therefore, when the via conductors are formed inside the first substrate, distances between the via conductors and the side surfaces of the first substrate 11 may be insufficient depending on the positions of the via conductors. Cracks may occur in the first substrate 11 at locations where the distance between the outer edge of the via conductor and the side surface of the first substrate 11 is not sufficient. However, the first via conductors 142 of the present embodiment are exposed from the first surface 11A to the second surface 11B, which reduces a possibility of such cracks. Even when other through-hole conductors need to be provided in order to mount a semiconductor element, a capacitor, or the like other than the element described above on the first substrate, wiring layout flexibility can be improved while reducing the possibility of cracks.

As illustrated in FIG. 2, the first via conductors 142 have portions overlapping the second via conductors 144 when viewed in plan. With this configuration, heat and current conduction paths are formed in straight lines and with large cross-sectional areas from the first surface 11A on which the element is mounted to the fourth surface 12B connected to the mounting substrate, further improving heat dissipation and an effect of reducing conductor resistance. As illustrated in FIG. 2, in the substrate 1, the cross-sectional area of the second via conductors 144 is larger than the cross-sectional area of the first via conductors 142. With such a configuration, heat transfer paths from the first surface 11A to the fourth surface 12B also extend in the X-Y plane direction, so heat is transferred to the fourth surface 12B while diffusing in the X-Y plane direction. Thus, heat dissipation can be further improved.

### Positioning of First Via Conductor 142

Here, positioning of the first via conductor 142 on the first substrate 11 will be described. FIG. 4 is a top view of the first substrate 11. FIG. 5 is a schematic plan view schematically illustrating an outer edge of the first via conductor 142 and a side of the first surface 11A when an angle θ illustrated in FIG. 4 is changed.

As illustrated in FIG. 4, the first substrate 11 may include the first via conductors 142 at the centers of opposite sides of the first surface 11A. This configuration increases a distance L between the first via conductor 142 and a side at which the first via conductor 142 is not located, thereby reducing a possibility of cracks in the first substrate 11 due to stress such as thermal stress caused by heat generated during use. The distance L can be defined as the shortest distance from the side where the first via conductor 142 is not located to a position where an extension line orthogonal to the side intersects the outer edge of the first via conductor 142. In manufacturing the substrate 1, when punching out the ceramic green sheet to be the first substrate 11, the distances between the outer edges of the first substrate 11 and the outer edges of the first via conductors 142 are large, so cracks are less likely to occur in the first substrate 11.

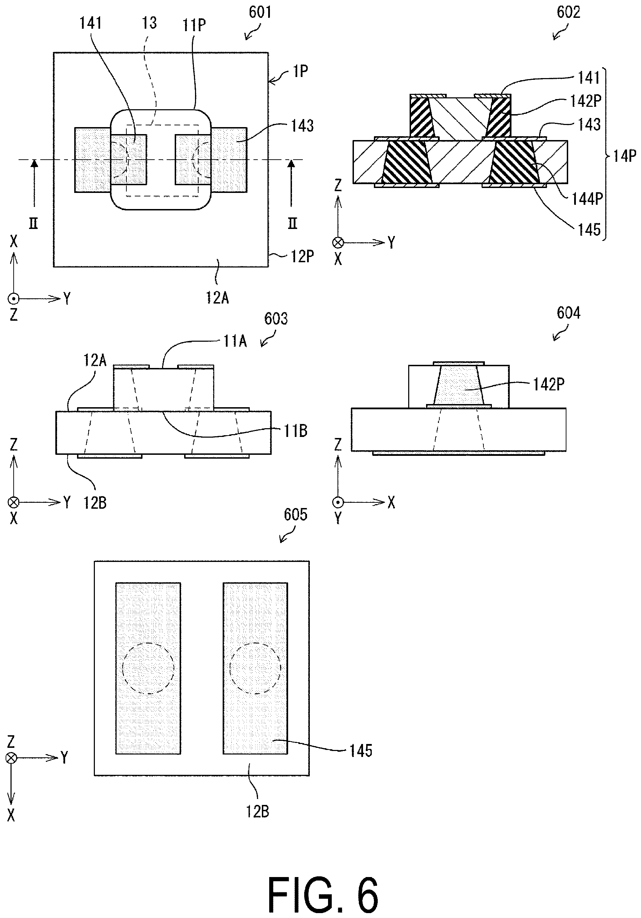

Here, when the first substrate 11 is viewed in plan, attention will be paid to an intersection of the outer edge of the first via conductor 142 and the side of the first surface 11A in a case where the shape of the first via conductor 142 is semi-circular or semi-elliptical when viewed in plan. An angle between a tangent to the outer edge of the first via conductor 142 at the intersection and the side of the first surface 11A is defined as an angle θ. In the first substrate 11, the angle θ may be from 70° to 110° (90° ± 20°). By setting the angle θ from 70° to 110°, the conductor cross section of the first via conductor 142 does not become small, and a thin portion (narrow portion) is less likely to be formed in the first substrate 11 between the first via conductor 142 and the side surface of the first substrate 11. Thus, the first substrate 11 has low conductor resistance and the likelihood of chipping or the like of the first substrate 11 at the narrow portion is reduced, resulting in a substrate with high connection reliability. First Variation
FIG. 6 includes a top view, a cross-sectional view, side views, and a bottom view of a substrate 1P that is a variation of the substrate 1. In FIG. 6, a view indicated by reference numeral 601 is the top view of the substrate 1P, and a view indicated by reference numeral 602 is the cross-sectional view taken along line II-II in the view indicated by reference numeral 601. In FIG. 6, a view indicated by reference numeral 603 is a side view of the substrate 1P when viewed from the negative direction of the X-axis, and a view indicated by reference numeral 604 is a side view of the substrate 1P when viewed from the positive direction of the Y-axis. A view indicated by reference numeral 605 in FIG. 6 is the bottom view of the substrate 1P.

A first substrate 11P according to a first variation includes first via conductors 142P. A cross-sectional area of the first via conductors 142P in a cross section parallel to the first surface 11A increases from the first surface 11A toward the second surface 11B. The cross-sectional area may increase stepwise from the first surface 11A toward the second surface 11B, or may gradually increase from the first surface 11A toward the second surface 11B. When the cross-sectional area gradually increases from the first surface 11A toward the second surface 11B, there are no corners where stress tends to concentrate between the first substrate 11P and the first via conductors 142P, thereby improving connection reliability.

The above configuration of the first via conductors 142P improves heat dissipation because heat from the element is transferred to the second substrate side while diffusing in a plane direction as well. Connection areas between the first via conductors 142P and the wiring layers 143 on a second substrate 12P are increased, thereby improving connection reliability. The large conduction cross-sectional area further reduces the conductor resistance compared with the first via conductors 142.

The second substrate 12P of the substrate 1P includes second via conductors 144P. The cross-sectional area of the second via conductors 144P in a cross section parallel to the third surface 12A increases from the third surface toward the fourth surface. With this configuration, a heat dissipation effect and a conductor resistance reduction effect in the second substrate 12 are further improved.

### Second Variation

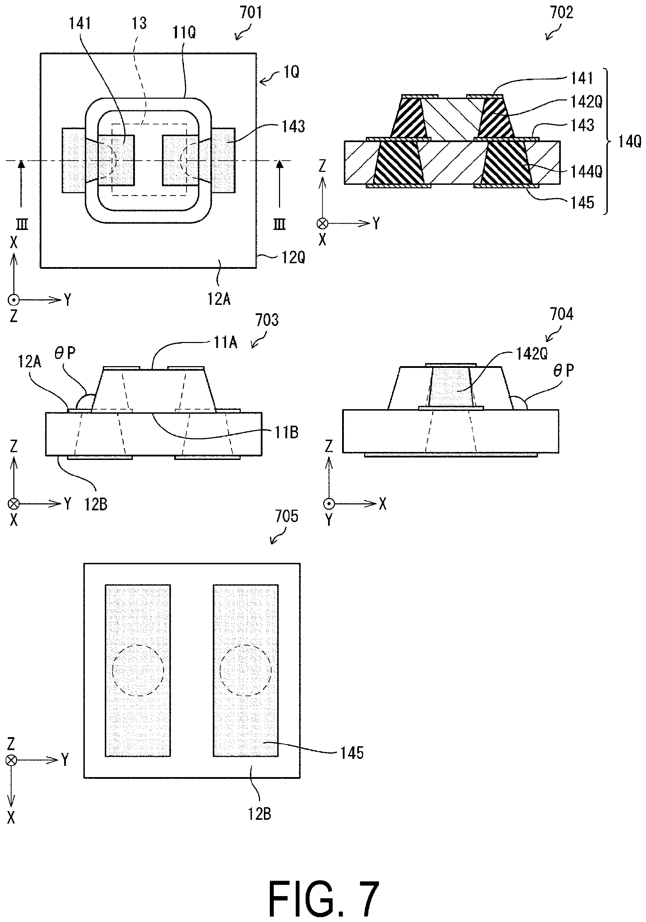

FIG. 7 includes a top view, a cross-sectional view, side views, and a bottom view of a substrate 1Q that is a variation of the substrate 1. In FIG. 7, a view indicated by reference numeral 701 is the top view of the substrate 1Q, and a view indicated by reference numeral 702 is a cross-sectional view taken along line III-III in the view indicated by reference numeral 701. In FIG. 7, a view indicated by reference numeral 703 is a side view of the substrate 1Q when viewed from the positive direction of the X-axis, and a view indicated by reference numeral 704 is a side view of the substrate 1Q when viewed from the positive direction of the Y-axis. A view indicated by reference numeral 705 in FIG. 7 is the bottom view of the substrate 1Q.

Side surfaces of a first substrate 11Q according to a second variation are inclined, and an angle θP between the side surfaces and the third surface 12A is an obtuse angle. Surfaces of the first via conductors 142Q exposed on the side surfaces of the first substrate 11Q may be flush with the side surfaces of the first substrate 11Q, and the exposed surfaces of the first via conductors 142Q may also be inclined. The angle between the exposed surfaces and the third surface 12A may be the same as the angle θP between the side surfaces and the third surface 12A. The angle θP is not limited, and may be, for example, from 95° to 110°. When the angle θP is in a range from 95° to 110°, the first via conductors 142Q in their entireties in a length direction are easily exposed on the side surfaces of the first substrate 11Q, thereby easily improving heat dissipation. The inclined surfaces of the first substrate 11Q can be formed, for example, by providing a clearance between dies in the step of punching out the ceramic green sheet to be the first substrate 11Q. To be more specific, the inclined surfaces can be formed by setting a diameter (length of one side) of a support die (female die) installed on a punching end surface side of the first substrate 11Q to be larger than a diameter (length of one side) of a punching die (male die) installed on a punching start surface side of the first substrate 11Q. The inclination angle (angle θP) of the first substrate 11Q can be adjusted by changing the size of the clearance between the male die and the female die.

In the substrate 1Q, the angle θP between the side surfaces of the first substrate 11Q and the third surface 12A is an obtuse angle, which reduces a possibility of cracks originating from the corners. This reduces the likelihood of disconnection of the wiring, thereby improving reliability. The substrate 1Q in which the angle θP is an obtuse angle has excellent heat dissipation because areas of the first via conductors 142Q exposed to the side surfaces of the first substrate 11Q are larger than that of the substrate in which the angle θP is a right angle. The first via conductors 142Q further increase a conductor cross-sectional area and increase thermal diffusion in a lateral direction, which further improves a conductor resistance reduction effect and a heat dissipation effect.

### Third Variation

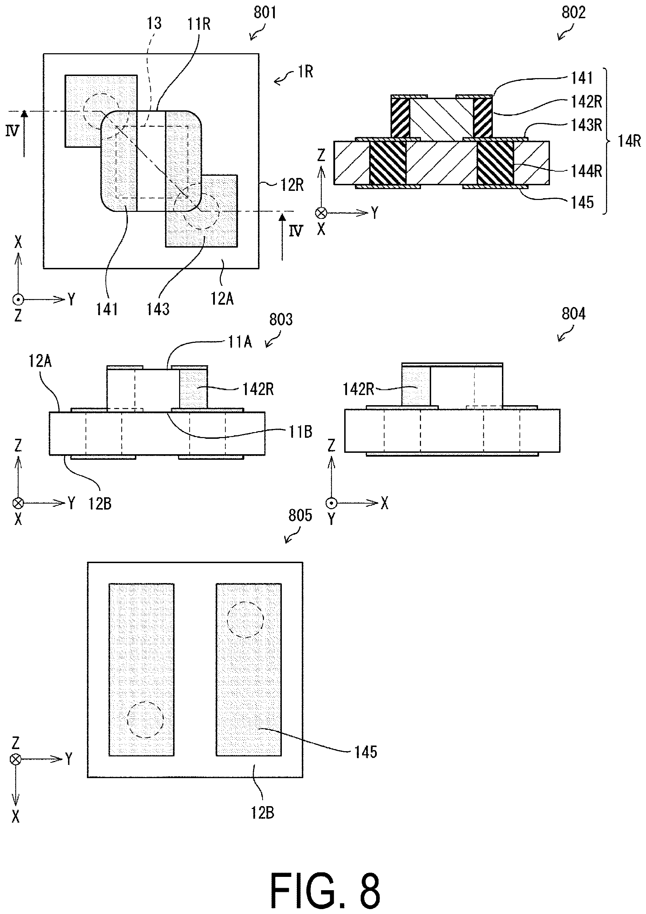

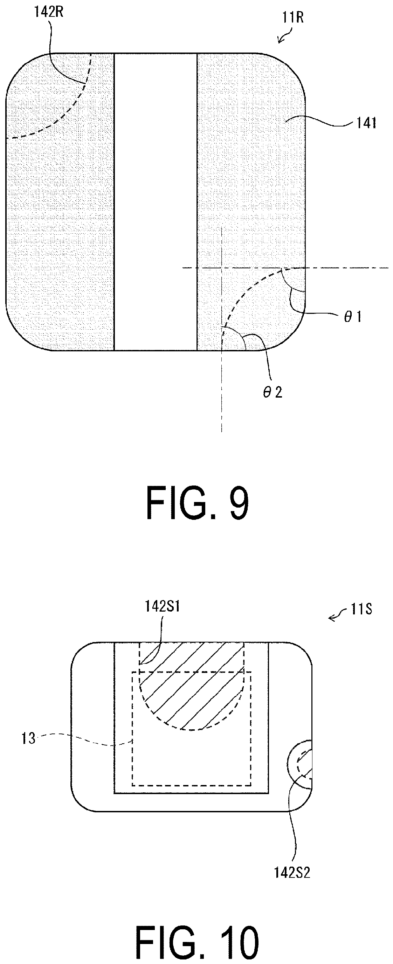

FIG. 8 includes a top view, a cross-sectional view, side views, and a bottom view of a substrate 1R that is a variation of the substrate 1. In FIG. 8, a view indicated by reference numeral 801 is the top view of the substrate 1R, and a view indicated by reference numeral 802 is a cross-sectional view taken along line IV-IV in the view indicated by reference numeral 801. In FIG. 8, a view indicated by reference numeral 803 is a side view of the substrate 1R when viewed from the negative direction of the X-axis, and a view indicated by reference numeral 804 is a side view of the substrate 1R when viewed from the positive direction of the Y-axis. A view indicated by reference numeral 805 in FIG. 8 is the bottom view of the substrate 1R. FIG. 9 is an enlarged top view of a first substrate 11R.

The substrate 1R according to a third variation has a rectangular shape, and includes first via conductors 142R at opposite corners of the first surface 11A. With this configuration, the distance between outer edges of the first via conductors 142R can be increased, thereby reducing the likelihood of cracks occurring in a portion between the first via conductors 142R of the first substrate 11R. By ensuring this distance, the likelihood of short circuit between the conductors can be reduced. Diameters of the first via conductors 142R can be increased, which further improves a conductor resistance reduction effect and a heat dissipation effect.

Here, attention is paid to intersections between the outer edges of the first via conductor 142R and the sides of the first surface 11A. Two angles (angles θ1 and θ2) between tangents to the outer edges of the first via conductor 142R at the intersections and the sides of the first surface 11A may be different from each other. The angles θ1 and θ2 may each be from 70° to 110° (90° ± 20°).

### Fourth Variation

FIG. 10 is a top view of a first substrate 11S that is a variation of the first substrate 11. As illustrated in FIG. 10, the first substrate 11S includes two first via conductors 142S1 and 142S2 of different sizes. The first via conductor 142S1 has a semi-elliptical shape, and part of the first via conductor 142S1 overlaps the element mounting region 13 when viewed in plan.

With the above configuration, the region overlapping the element mounting region 13 when viewed in plan is larger than that in the embodiment and variations described above. Consequently, heat dissipation can be further improved. In this case, the first via conductor 142S1 having a larger cross-sectional area may be used as ground potential, and the first via conductor 142S2 having a smaller cross-sectional area may be used as potential for power extraction. The first via conductor 142S1 may be connected to a wiring conductor through, for example, an electrically conductive bonding material (solder, brazing material, electrically conductive adhesive, etc.) placed on a lower surface of the first substrate 11S. On the other hand, the first via conductor 142S2 may be connected to a wiring conductor through a bonding wire. Alternately, one first via conductor 142S1 having a larger cross-sectional area may be provided only for heat dissipation, and two first via conductors 142S2 having a smaller cross-sectional area may be provided for electrical connection.

### Others

In the embodiment described above, an example in which the first substrate 11 and the second substrate 12 each have a single layer has been described. However, the first substrate 11 and the second substrate 12 may be a stacked body in which two or more insulating layers are stacked. By stacking the multiple insulating layers, a complicated wiring structure can be easily provided.

When the first substrate 11 and the second substrate 12 are stacked bodies in which multiple insulating layers are stacked, via conductors may be defined as conductors passing through the insulating layers. For example, an internal wiring layer may be provided between the insulating layers. In this case, the connection pad 141 and the terminal electrode 145 may be electrically connected by the first via conductor 142, the wiring layer 143, the internal wiring layer, and the second via conductor 144.

### Electronic Component

An electronic component according to the present disclosure includes the substrate 1 according to the present disclosure and an element. In the following, as an example, a case in which the element is a light emitting element 2, that is, a case in which the electronic component is a light emitting device 5 will be described.

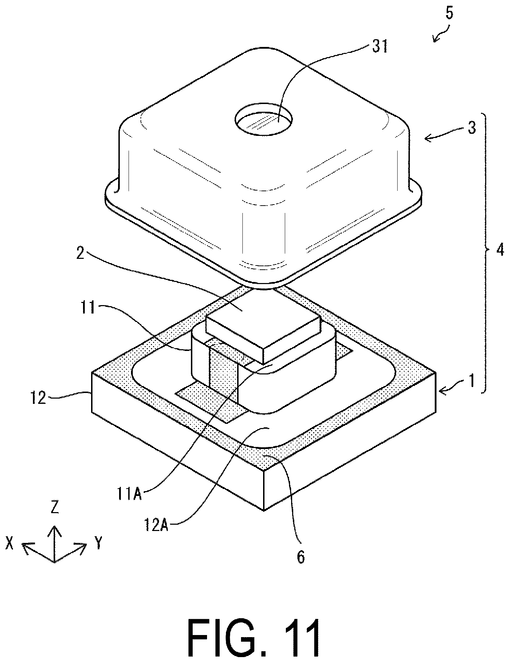

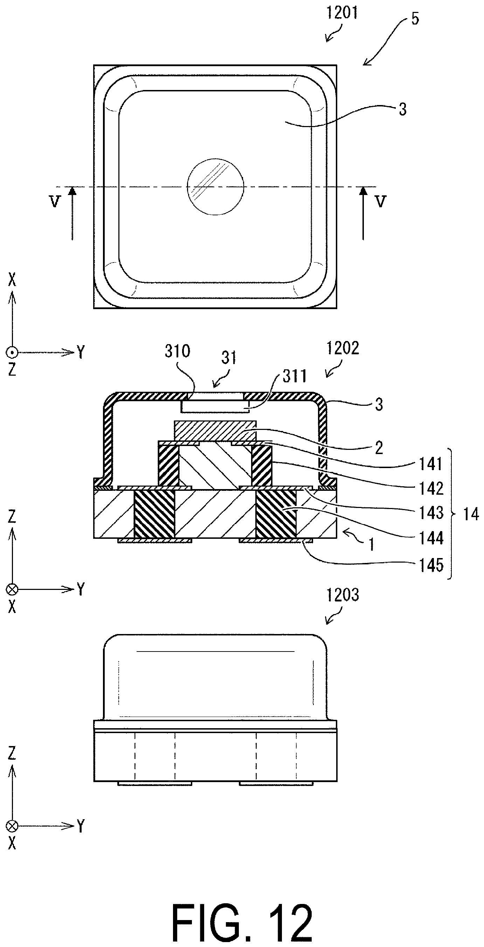

FIG. 11 is an exploded perspective view illustrating the light emitting device 5. FIG. 12 includes a top view, a cross-sectional view, and a side view of the light emitting device 5. In FIG. 12, a view indicated by reference numeral 1201 is the top view of the light emitting device 5. In FIG. 12, a view indicated by reference numeral 1202 is the cross-sectional view taken along line V-V in the view indicated by reference numeral 1201. In FIG. 12, a view indicated by reference numeral 1203 is the side view of the light emitting device 5 as viewed from a negative X-axis negative direction.

The light emitting device 5 includes the substrate 1 and the light emitting element 2. As illustrated in FIG. 11, when the light emitting element 2 is required to be hermetically sealed, the light emitting device 5 may include a lid 3. A configuration including the substrate 1 and the lid 3 is referred to as a package 4. That is, the light emitting device 5 can be said to include the package 4 and the light emitting element 2.

In the light emitting device 5, the light emitting element 2 mounted on the substrate 1 and an external electrical circuit are electrically connected by electrically connecting the terminal electrodes 145 provided, for example, on the lower surface of the substrate 1 to the external electrical circuit. In other words, the light emitting element 2 and the external electrical circuit are electrically connected to each other via the wiring conductors 14.

The light emitting element 2 and the connection pads 141 may be connected using connection members such as bonding wires, or may be flip-chip connected by solder or the like through terminals provided on a lower surface of the light emitting element 2. Alternatively, these connection methods may be used in combination.

Although not illustrated, the light emitting device 5 may include another semiconductor element and/or a passive element such as a capacitor in addition to the light emitting element 2, when needed. These components may be mounted on the first surface 11A of the first substrate 11 or the third surface 12A of the second substrate 12. Other semiconductor elements may include, for example, integrated circuits such as an application specific integrated circuit (ASIC). For example, the semiconductor element and/or the capacitor may be electrically connected to the light emitting element 2 and the substrate 1 by connection members such as bonding wires, or may be connected to the wiring conductors 14 of the substrate 1 by soldering.

In the example illustrated in FIG. 11, the light emitting element 2 is sealed and protected by the lid 3. In the example illustrated in FIG. 11, the light emitting device 5 includes the lid 3 that is box-shaped (cap-shaped) and collectively covers the light emitting element 2, the first substrate 11, and the wiring layers 143 on the upper surface of the second substrate 12.

The lid 3 is made of a material such as metal or resin, and is bonded to the substrate 1. The lid 3 may be bonded through a sealing bonding material. Examples of the sealing bonding material include, for example a resin adhesive, glass, and a brazing material including solder. When the lid 3 and the substrate 1 are bonded with a brazing material, a bonding metal layer 6 may be provided on the upper surface of the second substrate 12 so as to surround the first substrate 11 and the wiring layers 143 on the upper surface of the second substrate 12. When the lid 3 is made of metal, the lid 3 may be bonded to the bonding metal layer 6 on the second substrate 12 by welding such as seam welding or laser welding. In the case of bonding using the brazing material or the like, an overall heating by reflow heating is performed, whereas in the case of bonding by seam welding or laser welding, local heating of only the bonding portion can be performed. Since the light emitting element 2 is mounted on the first substrate 11, a space corresponding to the thickness of the first substrate 11 and a distance from the outer edge of the first substrate 11 to the inner edge of the bonding metal layer 6 is ensured. Thus, the light emitting element 2 can be separated by a large distance from the bonding metal layer 6 to be heated during bonding. Therefore, influence of heat on the light emitting element 2 can be reduced. The bonding metal layer 6 may be formed of, for example a metal film such as a plating film, a metallization layer, or the like. When the lid 3 is made of a material having low wettability (bondability) with a brazing material, such as resin, the bonding metal layer may also be formed on the lid 3.

The lid 3 includes a window 31 on an upper surface for emitting light. For example, the window 31 may be made by closing an opening portion 310 formed at a predetermined position of the lid 3 with a glass plate 311 that transmits light. The lid 3 can be used to mount a surface emitting LD such as a surface emitting LED or a vertical cavity surface emitting laser (VCSEL). Although the shape of the window 31 is circular in FIG. 11, the shape of the window 31 is not limited to being circular, and may be rectangular, polygonal, or the like. The size of the window 31 may also be changed as appropriate. The opening portion 310 may be provided on the upper surface or a side surface of the lid 3 depending on the direction in which the light emitting element 2 emits light.

In the light emitting device 5, the bonding metal layer 6 may be connected to ground potential, and the bonding metal layer 6 and the electrically conductive lid 3 made of metal or the like may be bonded or welded with an electrically conductive bonding material. With this configuration, the lid 3 is at ground potential, thereby providing a magnetic shield effect for the elements mounted inside the lid 3.

The shield effect can also be obtained by connecting an inner surface of the lid 3 and the first via conductor 142 with an electrically conductive bonding material. In this case, a metal bonding material such as solder may be used as a bonding material for connecting the inner surface of the lid 3 and the first via conductor 142. The metal bonding material such as solder has excellent thermal conductivity, allowing the lid 3 to serve as a radiator, which also improves heat dissipation.

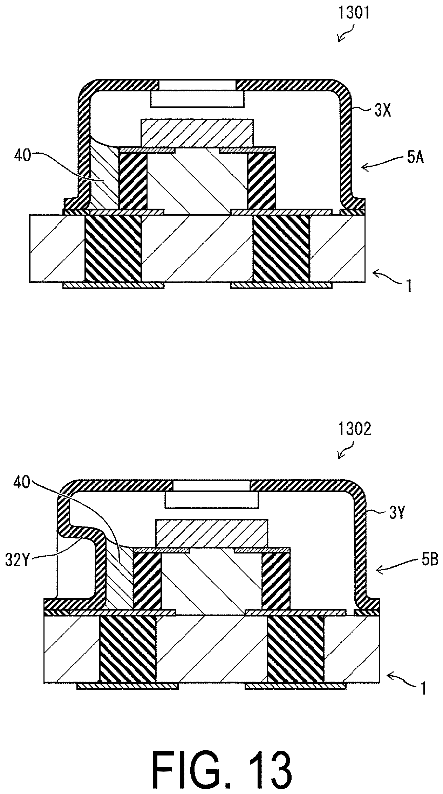

FIG. 13 includes cross-sectional views of a light emitting device 5A and a light emitting device 5B in each of which the inner surface of the lid 3 and the first via conductor 142 are bonded with a bonding material 40. In a lid 3X included in the light emitting device 5A indicated by reference numeral 1301 in FIG. 13, one of four side walls is located near the first via conductor 142 at ground potential. A lid 3Y included in the light emitting device 5B indicated by reference numeral 1302 in FIG. 13 has a recessed portion 32Y in which part of a side wall protrudes inward. As in the light emitting devices 5A and 5B illustrated in FIG. 13, by placing the inner surface of the lid 3 facing the first via conductor 142 close to the first via conductor 142, connection between the lid 3 and the first via conductor 142 is facilitated.

In the example illustrated in FIG. 11, the substrate 1 and the lid 3 have a rectangular shape when viewed in plan, but the substrate 1 and the lid 3 may have another shape such as circular or polygonal when viewed in plan. The substrate 1 may have multiple element mounting regions 13, and the lid 3 may have multiple windows 31.

Since the light emitting device 5 includes the substrate 1 having a conductor resistance reduction effect and a heat dissipation effect or the package 4 including the substrate 1, an energy-saving effect or reliability as an electronic component can be improved.

### Fifth Variation

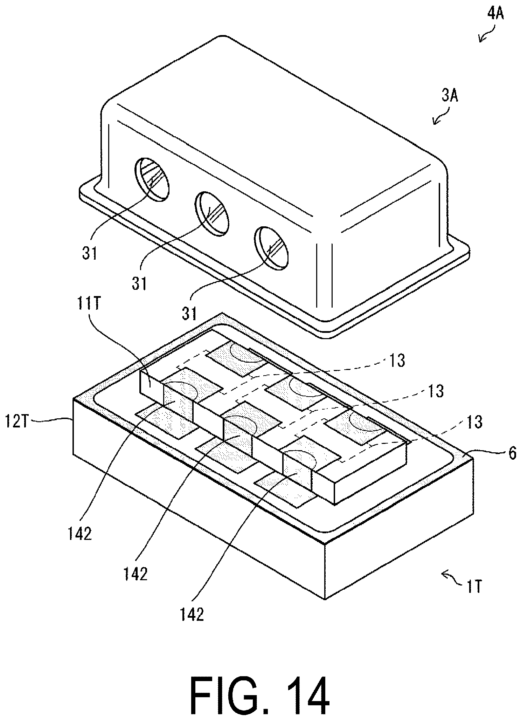

FIG. 14 is an exploded perspective view of a package 4A. The package 4A includes a substrate 1T that is a variation of the substrate 1, and a lid 3A that is a variation of the lid 3.

The substrate 1T has three element mounting regions 13 on a first substrate 11T, and can be used, for example, as a substrate on which three types of edge emitting LDs that respectively emit red (R) light, green (G) light, and blue (B) light are mounted as elements. The lid 3A has three windows 31 corresponding to the multiple elements.

FIG. 14 illustrates an example in which the substrate 1T has three element mounting regions 13, but the number of the element mounting regions 13 is not limited to this example. The number of element mounting regions 13 that the substrate 1T has and the number of the windows 31 that the lid 3A has can be set freely.

### Sixth Variation

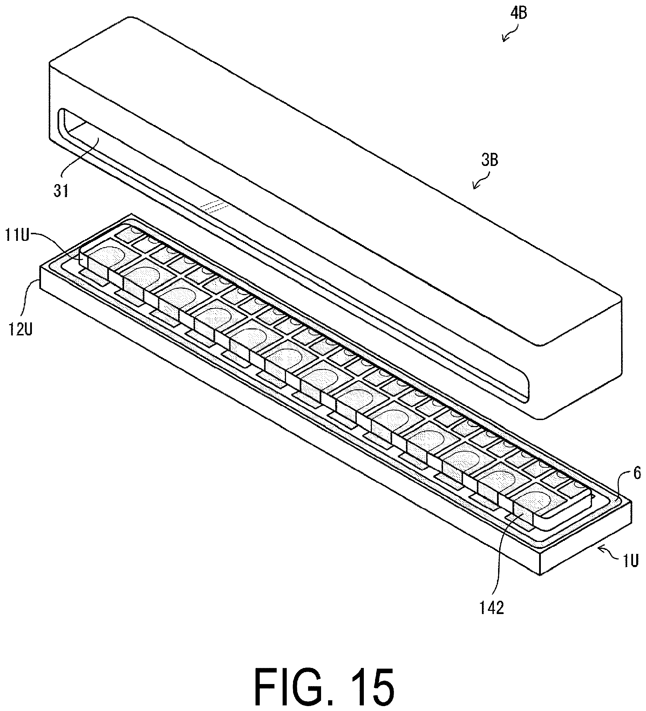

FIG. 15 is an exploded perspective view of a package 4B. The package 4B includes a substrate 1U that is a variation of the substrate 1, and a lid 3B that is a variation of the lid 3.

The substrate 1U has multiple element mounting regions 13 on a first substrate 11U, and has a rectangular shape elongated in an arrangement direction of the elements. The substrate 1U can be used, for example, as a substrate on which edge emitting LDs are mounted. The lid 3B has one window 31 for the multiple elements included in the first substrate 11U of the element. The window 31 of the lid 3B has a rectangular shape elongated in the arrangement direction of the elements. As in the case of the lid 3B, when distances between the elements mounted on the substrate 1U are small, one window 31 may be provided in the lid 3B for the multiple elements. When the linearity of light emitted from each of the elements is high and appropriate clearances are ensured between the elements, adjacent light beams do not interfere with each other even when the window 31 has one rectangular shape for the multiple elements.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1, 1P, 1Q, 1R, 1T Substrate
11, 11P, 11Q, 11R, 11S, 11T, 11U First substrate
11A First surface
11B Second surface
12, 12P, 12Q, 12R, 12T, 12U Second substrate
12A Third surface
12B Fourth surface
13 Element mounting region
14 Wiring conductor
141 Connection pad
142, 142P, 142Q, 142R, 142S1, 142S2 First via conductor
143 Wiring layer
144, 144P Second via conductor
145 Terminal electrode
2 Light emitting element (element)
3, 3A, 3B Lid
4, 4A, 4B Package
5, 5A, 5B Light emitting device (electronic component)

## Claims

1. A substrate comprising:
a first substrate having a first surface on which an element is to be mounted, a second surface located opposite the first surface, and a first side surface connecting the first surface and the second surface;
a second substrate larger than the first substrate and having a third surface supporting the first substrate and a fourth surface located opposite the third surface; and
first via conductors configured to electrically connect the first surface and the second surface and exposed on the first side surface of the first substrate from the first surface to the second surface.

2. The substrate according to claim 1, wherein
a cross-sectional area of the first via conductors in a cross section parallel to the first surface increases from the first surface toward the second surface.

3. The substrate according to claim 2, wherein
the first side surface of the first substrate is inclined, and an angle between the first side surface and the third surface is an obtuse angle.

4. The substrate according to any one of claims 1 to 3, wherein
the first substrate has a rectangular shape, and
the first via conductors are located at respective centers of opposite sides of the first surface.

5. The substrate according to any one of claims 1 to 3, wherein
the first substrate has a rectangular shape, and
the first via conductors are respectively located at opposite corners of the first surface.

6. The substrate according to any one of claims 1 to 5, wherein
when viewed in plan, an angle between a tangent to an outer edge of each of the first via conductors at an intersection of the outer edge of each of the first via conductors and a side of the first surface and the side of the first surface is 90° ± 20°.

7. The substrate according to any one of claims 1 to 6, wherein
at least one of the first via conductors has a portion overlapping a region where the element is to be mounted when viewed in plan.

8. The substrate according to any one of claims 1 to 7, wherein
the second substrate comprises second via conductors configured to electrically connect the third surface and the fourth surface, and
at least one of the first via conductors has a portion overlapping one of the second via conductors when viewed in plan.

9. A package comprising:
the substrate according to any one of claims 1 to 8; and
a lid.

10. An electronic component comprising:
the substrate according to any one of claims 1 to 8 or the package according to claim 9; and
an element mounted in the package.

11. A light emitting device comprising:
the substrate according to any one of claims 1 to 8 or the package according to claim 9; and
an element mounted in the package, wherein
the element is a light emitting element.
